# EUROPEAN PATENT APPLICATION

(11) **EP 1 476 000 A1**
(43) Date of publication of application: **10.11.2004**
(21) Application number: 03703183.8
(22) Date of filing: 05.02.2003
(51) Int. Cl.: H05B 33/04, H05B 33/12, H05B 33/10, H05B 33/14

(54) **ORGANIC EL DISPLAY AND ITS PRODUCTION METHOD**

(30) Priority: 12.02.2002 JP 2002033814
(71) Applicant: IDEMITSU KOSAN CO., LTD., Tokyo 100-8321 (JP)
(72) Inventor: KUMA, Hitoshi, Sodegaura-shi, Chiba 299-0293 (JP); EIDA, Mitsuru, Sodegaura-shi, Chiba 299-0293 (JP); HOSOKAWA, Chishio, Sodegaura-shi, Chiba 299-0293 (JP)
(74) Representative: Gille Hrabal Struck Neidlein Prop Roos
(86) International application number: PCT/JP2003/001179
(87) International publication number: WO 2003/069957

(57) **Abstract**

An organic EL device (2) and an sealing layer (3) are formed on a supporting substrate (1). The top surface (31) of the sealing layer is made repellent to ink. Ink is printed by an ink jet method to form a coloring layer (4). A flattening layer (8) is formed, and thereafter a sealing substrate (5) is bonded. Since the coloring layer (4) is not previously formed on the sealing substrate (5), no precise positioning for bonding the sealing substrate (5) to the supporting substrate (1) is needed. The viewing angle properties are enhanced since the distance between the organic EL device (2) and the coloring layer (4) can be small. Thus, there are provided an organic EL display of top emission type with a high production yield and excellent viewing angle properties and its production method.

## Description

### Technical Field

This invention relates to an organic electroluminescence (EL) display and its production method. More specifically, the invention relates to an organic EL display of top emission type where light is taken out from a sealing substrate side, and its production method.

### Background Art

An organic EL display is constructed from organic EL devices with an organic luminescent medium containing organic luminescent molecules held between opposite electrodes. If a voltage is applied across the electrodes, electrons injected from an electrode recombine with holes from another electrode in an organic emitting layer of the organic luminescent medium. The organic luminescent molecules change to the exited state by the recombination energy and then return to the base state. At this time energy is discharged. The organic EL device emits light by taking out this energy as light.

An organic EL display constructed from organic EL devices of such luminescent principle is completely solid and characterized by excellent visibility, light weight, thin thickness, and low driving voltage of several volts. Thus organic EL displays are expected to be used as color displays and have been eagerly researched at present.

Such organic EL displays are roughly classified into two types, bottom emission and top emission.

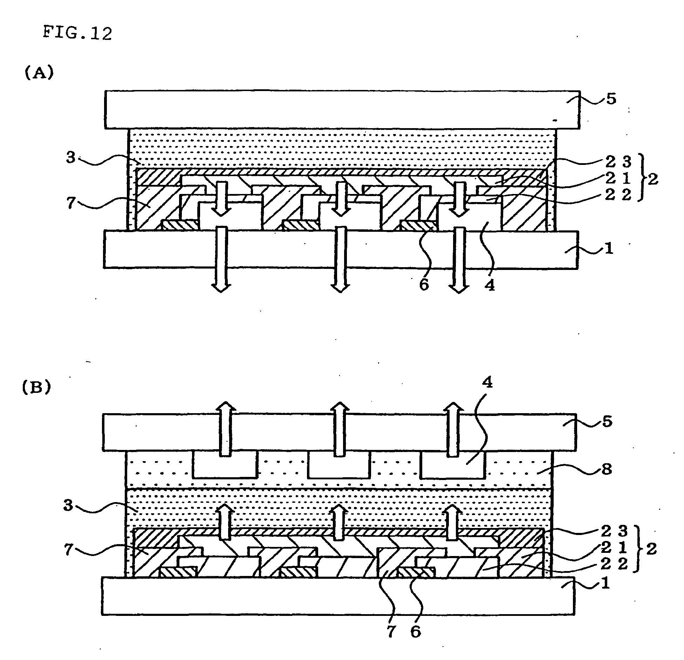

Fig. 12 (A) shows an example of organic EL displays of bottom emission type.

As shown in Fig. 12 (A), in the organic EL display of bottom emission type, a coloring layer 4 and thin film transistors (TFT) 6 are formed on a supporting substrate 1 and further an under electrode 22, an insulative member 7, an organic luminescent medium 21, an upper electrode 23 and a sealing layer 3 are laminated thereon in this order with a sealing substrate 5 being on the uppermost surface. The under electrode 22, organic luminescent medium 21 and upper electrode 23 constitute an organic EL device 2. Arrows show the direction of taking out light.

In the organic EL display of bottom emission type, light emitted from the organic luminescent medium 21 is changed in the coloring layer 4 so that desired light is taken out from the supporting substrate 1 side.

Fig. 12 (B) shows an example of organic EL displays of top emission type.

As shown in Fig. 12 (B), in the organic EL display of top emission type, an under electrode 22 and TFTs 6 are formed on a supporting substrate 1 and further an insulative member 7, an organic luminescent medium 21, an upper electrode 23, a sealing layer 3, a flattening layer 8 and a coloring layer 4 are laminated thereon in this order with a sealing substrate 5 being on the uppermost surface. The under electrode 22, organic luminescent medium 21 and upper electrode 23 constitute an organic EL device 2. Arrows show the direction of taking out light.

In the organic EL display of top emission type, light emitted from the organic luminescent medium 21 is changed in the coloring layer 4 so that desired light is taken out from the sealing substrate 5 side.

Hitherto organic EL displays are mainly of bottom emission type as shown in Fig. 12 (A) since the displays of this type are more easily produced in a high yield described later.

An under electrode 22 is formed on a coloring layer 4 in the organic EL display of bottom emission type as shown in Fig. 12 (A). Thus the under electrode 22 must be connected to TFTs 6 formed directly on the supporting substrate 1 with steps. It is difficult to connect the under electrode 22 to the TFTs 6 since the electrode 22 is liable to be disconnected in the steps.

Further, in the bottom emission type, light cannot be taken out from parts where TFTs 6 are formed so that it is difficult to increase the opening ratio of pixels. The opening ratio is the ratio of actual light-emitting area in pixels.

In contrast, in the top emission type, an under electrode 22 can be flattened since both the TFTs 6 and under electrode 22 can be formed on the supporting substrate 1. As a result the under electrode 22 can be easily connected to the TFTs 6 with small possibility that an under electrode 22 is disconnected by steps. In addition, the TFTs 6 do not reduce the opening ratio and the opening ratio can be then increased more than the bottom emission type.

Therefore the organic EL display of top emission type is superior to that of bottom emission type in order to suppress the disconnection of under electrode 22 by steps and obtain a high opening ratio.

However a coloring layer 4 and organic luminescent medium 21 can be sequentially formed on a supporting substrate 1 in the bottom emission type, while a coloring layer 4 cannot be formed above an organic luminescent medium 21 by ordinary photolithography and etching in the top emission type, because the organic luminescent medium 21 may be damaged. Thus the organic EL display of top emission type is produced by the following method. A coloring layer 4 and flattening layer 8 are usually formed on a sealing substrate 5 on the sealing substrate side, while TFTs 6, organic EL device 2 and sealing layer 3 are formed on a supporting substrate 1 on the supporting substrate side. The sealing substrate 5 with the coloring layer 4 and the like thereon is adhered to the supporting substrate 1 with the organic EL device 2 and the like thereon. At this time it is required to precisely position the supporting substrate side against the sealing substrate side at the positions of dots of matrix. Such positioning is difficult so that the organic EL display of top emission type has a production yield lower than that of bottom emission type.

An organic EL device 2 can be formed just above a coloring layer 4 in the bottom emission type, while a sealing layer 3 and a flattening layer 8 are interposed between an organic EL device 2 and a coloring layer 4 for the adhesion of the supporting and sealing substrates 1, 5 in the top emission type. The viewing angle properties of this type are degraded by the thickness of these layers. The viewing angle properties are the properties about color mixture dependent on an angle at which a user watches.

The invention has been made to solve the above-mentioned problems. An object of the invention is to provide an organic EL display with a high production yield and excellent viewing angle properties without the formation of a coloring layer on a sealing substrate side, and its production method.

### Disclosure of the Invention

In order to attain the above object, the inventors have made much effort. They have found that if a coloring layer can be precisely positioned on the side of a supporting substrate without damaging an organic luminescent medium and so on even in the case of the top emission type, the precise positioning is not requested when adhering a sealing substrate and thus a production yield can be enhanced. Further if a coloring layer can be formed directly on a sealing layer, viewing angle properties can be improved due to a narrower distance between the coloring layer and the organic EL device.

According to a first aspect of the invention, there is provided an organic EL display comprising: an organic EL device which emits light, a sealing layer sealing the organic EL device, and a coloring layer, formed on the sealing layer, which changes the light emitted from the organic EL device.

According to a second aspect of the invention, there is provided the organic EL display according to the first aspect, wherein part of a surface contacting with the coloring layer of the sealing layer is repellent to ink and the coloring layer is formed on part other than the ink-repellent part.

According to a third aspect of the invention, there is provided an organic EL display comprising: an organic EL device which emits light, a sealing layer sealing the organic EL device, and a coloring layer, formed on the sealing layer, which changes the light emitted from the organic EL device, the coloring layer being formed in concave parts of the sealing layer.

It is preferred that rise parts are provided inside or on the organic EL device in a non-opening area to provide convex parts formed by the rise parts in the non-opening area of the sealing layer and the concave parts in the areas between the convex parts.

According to a fourth aspect of the invention, there is provided an organic EL display comprising: an organic EL device which emits light, a sealing layer sealing the organic EL device; and a coloring layer, formed on the sealing layer, which changes the light emitted from the organic EL device, the coloring layer being ink-permeable layers included in an ink-receiving layer formed on the sealing layer.

According to a fifth aspect of the invention, there is provided an organic EL display comprising: an organic EL device which emits light, a sealing layer sealing the organic EL device and containing an ultraviolet-ray shading material, and a coloring layer, formed on the sealing layer, which changes the light emitted from the organic EL device.

According to a sixth aspect of the invention, there is provided an organic EL display comprising: an organic EL device which emits light, a sealing layer sealing the organic EL device, an ultraviolet-ray reflecting multi-layer film formed on the sealing layer, and a coloring layer, formed on the multi-layer film, which changes the light emitted from the organic EL device.

According to a seventh aspect of the invention, there is provided an organic EL display comprising: an organic EL device which emits light, a sealing layer sealing the organic EL device, a polymer containing an ultraviolet-ray absorber, provided on the sealing layer, and a coloring layer, formed on the polymer containing an ultraviolet-ray absorber, which changes the light emitted from the organic EL device.

According to an eighth aspect of the invention, there is provided an organic EL display according to the first to seventh aspects, wherein the organic EL device, the sealing layer and the coloring layer are laminated on a supporting substrate in this order and further sealed thereon by the sealing substrate.

According to the above first to eighth aspects, the coloring layer is formed directly on the sealing layer and there is no flattening layer between the coloring layer and the organic EL device. Thus the distance between the coloring layer and the organic EL device is reduced, thereby improving the viewing angle properties.

The distance between the coloring layer and the organic EL device is preferably 5µm or less, more preferably 1µm or less.

According to the first to eighth aspect, there is provided an active driving type organic EL display by forming TFT.

According to an ninth aspect of the invention, there is provided a method for producing an organic EL display comprising: forming an organic EL device which emits light, forming a sealing layer sealing the organic EL device, imparting ink-repellency to part of a surface of the sealing layer, and applying ink on a surface of the sealing layer other-than the ink-repellent part to form a coloring layer.

The ink-repellency is preferably imparted by fluorine plasma treatment.

The ink-repellency is preferably imparted by application of a fluorine polymer or a silicone polymer.

The coloring layer can be formed more selectively and precisely by imparting ink-repellency on the surface of the sealing layer in a pattern.

According to a tenth aspect of the invention, there is provided a method for producing an organic EL display comprising: forming an organic EL device which emits light, forming rise parts in a non-opening area on the organic EL device, forming a sealing layer sealing the organic EL device on the rise parts, and forming a coloring layer in concave parts of the sealing layer, the concave parts being defined between convex parts formed by the rise parts.

According to a eleventh aspect of the invention, there is provided a method for producing an organic EL display comprising: forming rise parts in a non-opening area above an under electrode, forming an organic EL medium and an upper electrode on the rise parts to form an organic EL device with the organic luminescence medium held between the under and the upper electrodes, forming a sealing layer sealing the organic EL device thereon, and forming a coloring layer in concave parts of the sealing layer, the concave parts being defined between convex parts formed by the rise parts.

According to a twelfth aspect of the invention, there is provided a method for producing an organic EL display comprising: forming an organic EL device which emits light, forming a sealing layer sealing the organic EL device, forming concave parts by selectively removing a surface of the sealing layer in a non-opening area, and forming a coloring layer in the concave parts of the sealing layer.

According to a thirteenth aspect of the invention, there is provided a method for producing an organic EL display comprising: forming an organic EL device which emits light, forming a sealing layer sealing the organic EL device, forming concave parts by using a plain pattern which surrounds a non-opening area of the sealing layer in lattice (igeta) form, and forming a coloring layer in the concave parts of the sealing layer.

According to the above tenth to thirteenth aspects, the coloring layer is formed in concave parts. Thus the coloring layer can be formed more selectively and precisely because of little leakage of dye.

According to a fourteenth aspect of the invention, there is provided a method for producing an organic EL display comprising: forming an organic EL device which emits light, forming a sealing layer sealing the organic EL device, forming an ink-receiving layer on the sealing layer, and forming a coloring layer by penetrating ink at certain positions of the ink-receiving layer.

According to a fifteenth aspect of the invention, there is provided a method for producing an organic EL display comprising: forming an organic EL device which emits light, forming a sealing layer containing an ultraviolet-ray shading material, which seals the organic EL device, and forming a coloring layer on the sealing layer by ultraviolet-ray photolithography.

Preferred materials shading an ultraviolet-ray include indium tin oxide (ITO), indium zinc oxide (IZO), zirconium oxide (ZnO), or combinations thereof.

According to a sixteenth aspect of the invention, there is provided a method for producing an organic EL display comprising: forming an organic EL device which emits light, forming a sealing layer sealing the organic EL device, forming an ultraviolet-ray reflecting multi-layer film on the sealing layer, and forming a coloring layer on the multi-layer film by ultraviolet-ray photolithography.

According to a seventeenth aspect of the invention, there is provided a method for producing an organic EL display comprising: forming an organic EL device which emits light, forming a sealing layer sealing the organic EL device, applying a polymer containing an ultraviolet-ray absorber on a top surface of the sealing layer, and forming a coloring layer on the polymer containing an ultraviolet-ray absorber by ultraviolet-ray photolithography.

According to an eighteenth aspect of the invention, there is provided the method for producing an organic EL display according to the ninth to seventeenth aspect, wherein the organic EL device, the sealing layer and the coloring layer are formed on a supporting substrate, and then a sealing substrate is adhered with the supporting substrate.

According to the above fifteenth and eighteenth aspects, the coloring layer can be formed more selectively and precisely by photolithography.

According to the above ninth to eighteenth aspects, the coloring layer can be formed on the sealing layer without damaging the organic EL device.

Especially, in the case that an organic EL display of top emission type is produced by adhering a supporting substrate and a sealing substrate like the eighteenth aspect, the precise positioning thereof is not required so that its production yield increases.

Since a flattening layer is also not required between a coloring layer and an organic EL device, the distance therebetween becomes small to improve the viewing angle properties.

In the production method according to the ninth to fourteenth aspects the coloring layer is formed preferably by a printing method, more preferably an ink jet method.

Printing methods such as an ink jet method are carried out more easily than photolithography but they can make highly precise patterns.

### Brief Description of the Drawings

Fig. 1 is a diagram for explaining the structure of an organic EL display of a first embodiment;
Figs. 2 (A) to (C) are sectional views of steps for explaining a production method of the organic EL display according to the first embodiment;
Fig. 3 is a diagram for explaining the structure of an organic EL display of a second embodiment;
Figs. 4 (A) to (E) are sectional views of steps for explaining a production method of the organic EL display according to the second embodiment;
Fig. 5 is a diagram for explaining the structure of an organic EL display of a third embodiment;
Figs. 6 (A) to (C) are sectional views of steps for explaining a production method of the organic EL display according to the third embodiment;
Fig. 7 is a diagram for explaining the structure of an organic EL display of a fourth embodiment;
Figs. 8 (A) to (C) are sectional views of steps for explaining a production method of the organic EL display according to the fourth embodiment;
Fig. 9 is a circuit diagram showing the connection structure of electric switches with TFTs;
Fig. 10 is a plane view showing the connection structure of electric switches with TFTs;
Fig. 11 is a view showing the steps of forming a polysilicon TFT; and
Fig. 12 (A) is a diagram showing the structure of an organic EL display of bottom emission type, while Fig. 12 (B) is a diagram showing the structure of an organic EL display of top emission type.

### Best Modes for Carrying Out the Invention

### [First Embodiment]

Referring to the drawings, an organic EL display and its production method according to a first embodiment of the invention will be described hereinafter.

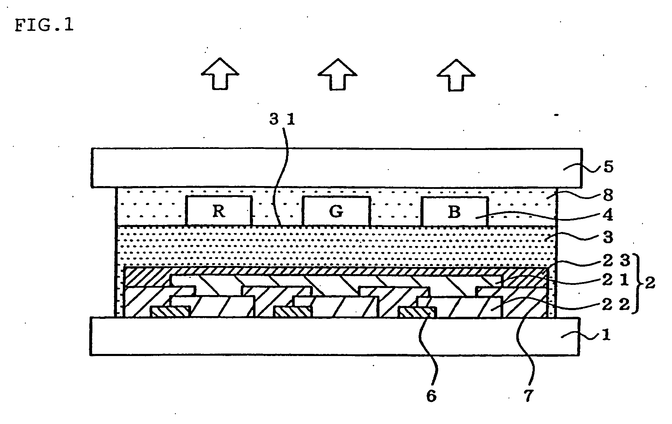

Fig. 1 is a diagram for explaining the structure of the organic EL display of the first embodiment.

As shown in this figure, in the organic EL display, TFTs 6 and under electrode 22 are formed on a supporting substrate 1, and an insulator 7, organic luminescent medium 21, upper electrode 23, sealing layer 3, coloring layer 4 and flattening layer 8 are laminated thereon in this order, a sealing substrate 5 being on the uppermost surface. The under electrode 22, organic luminescent medium 21 and upper electrode 23 constitute an organic EL device 2. Arrows show the direction in which light is taken out.

If a voltage is applied between the under and upper electrodes 22, 23, the organic luminescent medium 21 held by them emits light and the light passes via the sealing layer 3 to the coloring layer 4. The coloring layer 4 absorbs and converts the light to red, green and blue lights at need. These three color lights are taken out to the outside via the flattening layer 8 and sealing substrate 5.

Numeral 31 shows the top surface of the sealing layer 3. The coloring layer 4 is formed on this surface. In this embodiment, entire the surface 31 except the parts where the coloring layers 4 are formed is repellent to ink.

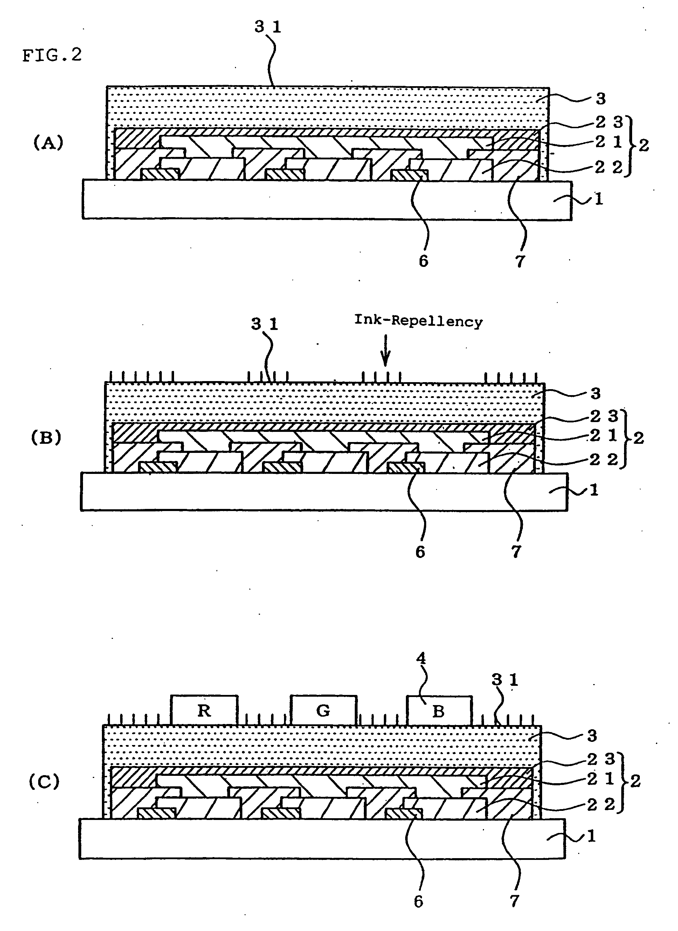

Next, the production method of this organic EL display will be explained with reference to Fig. 2.

This method contains the steps of forming TFTs 6 on a supporting substrate 1, forming an organic EL device 2 on the supporting substrate 1, sealing the organic EL device 2 by a sealing layer 3, giving repellency to specified parts of the top surface 31 of the sealing layer, applying ink containing materials of coloring layer 4 to the surface 31 to form the coloring layer 4, forming a flattening layer 8 on the coloring layer 4, and arranging a sealing substrate 5.

A TFTs 6 and an organic EL device 2 are firstly formed on a supporting substrate 1 and a sealing layer 3 is formed thereon (Fig. 2(A)). The TFTs 6, organic EL device 2 and sealing layer 3 can be formed by the method described later or known method.

Ink-repellency is imparted to part of the top surface 31 of the sealing layer 3 (Fig. 2(B)). Methods of imparting ink-repellency include fluorine plasma treatment, application of fluorine polymers or silicone polymers, and surface fluorine treatment.

Next coloring layers 4 are formed on the non-repellent parts of the top surface 31 (Fig. 2(C)).

In this embodiment, ink containing materials of coloring layer 4 is attached at certain positions of the surface 31 by an ink-jet method to form the coloring layer 4.

Ink is repelled on the repellent parts of surface 31. Thus ink is hardly attached to the repellent parts so that the coloring layers 4 can be formed in a desired pattern.

Ink can be precisely placed and deposited by printing methods such as an ink-jet method, thereby enabling the formation of high precision pattern.

Further the coloring layers 4 can be formed without damaging the organic luminescent medium 21 because they are formed by attaching ink to the surface of the sealing layer 3.

Thereafter a flattening layer 8 is formed by any known method and a sealing substrate 5 is then adhered to obtain the structure shown in Fig. 1.

In this embodiment, ink-repellency is imparted to certain areas of top surface of the sealing layer 3. At this time, for example, when coloring layers 4 of the same color are arranged per pixel row, ink-repellent areas are preferably arranged along pixel rows in groove form.

In the case where coloring layers 4 of three primary colors are arranged in stripe form, each coloring layer 4 can be easily precisely placed by the above method, since each coloring layer 4 can be deposited in an area other than groove-like ink-repellent areas.

The precise positioning of the supporting substrate 1 and sealing substrate 5 is not required at the time of adhering them since the coloring layers 4 are formed on the supporting substrate 1 side. Thus even if the display is of top emission type, its production yield can be increased.

In the case where coloring layers 4 are formed on a sealing substrate 5, a flattening layer 8 is provided for adhesion. However in this embodiment, there is not a flattening layer 8 between the coloring layer 4 and organic EL device 2 since the coloring layer 4 is formed on the sealing layer 3. As a result, the distance between the coloring layer 4 and organic EL device 2 is small and therefore the viewing angle properties are enhanced.

We will describe ink used in the ink jet method later.

### [Second Embodiment]

An organic EL display and its production method according to a second embodiment of the invention will be described with reference to drawings.

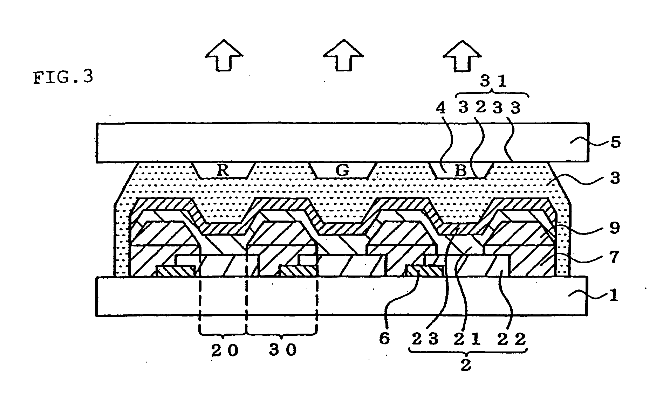

Fig. 3 is a diagram for explaining the structure of the organic EL display of the second embodiment. The same members as the first embodiment are denoted by the same reference numerals and their detail explanation is omitted.

In this display, numeral 20 denotes an opening area and numeral 30 denotes a non-opening area. In only the opening area 20, an organic luminescent medium 21 emits light since the medium 21 is sandwiched between under and upper electrodes 22, 23. The light is taken out to the outside via a coloring layer 4. That is, light is taken out in the opening area 20 but light is not taken out in the non-opening area 30.

In the second embodiment, part of the surface 31 is not ink-repellent but concave parts 32 are formed in at least part of the opening area 20 on the top surface 31 of a sealing layer instead. The coloring layers 4 are formed in the concave parts 32.

Convex parts 33 of the sealing layer 3 and coloring layers 4 form a plane so that a flattening layer can be omitted.

To form such concave parts 4, rise members 9 are provided on at least part of insulative members 7 between under electrodes 22. The areas of the top surface 31 just above the rise members 9 are the convex parts 33 that are formed by the rise members 9. The areas between the convex parts 33 define the concave parts 32.

The rise members 9 may be formed by printing a resin such as epoxy resins or depositing an inorganic material. They preferably have a height of about 1µm to about 10µm.

In this embodiment, the rise members 9 have a section of trapezoid. The section of trapezoid prevents disconnection of the organic luminescent medium 21 and upper electrode 23 that are formed on the rise members 9. However the shape of rise members 9 is not limited to trapezoid so far as the concave parts can be formed in the sealing layer 3.

For example, when coloring layers 4 of the same color are arranged per pixel row, concave parts 32 are preferably arranged along pixel rows in groove form.

In the case where coloring layers 4 of three primary colors are arranged in stripe form, each coloring layer 4 can be easily precisely placed by the above method, since each coloring layer 4 can be deposited in a groove-like concave part 32.

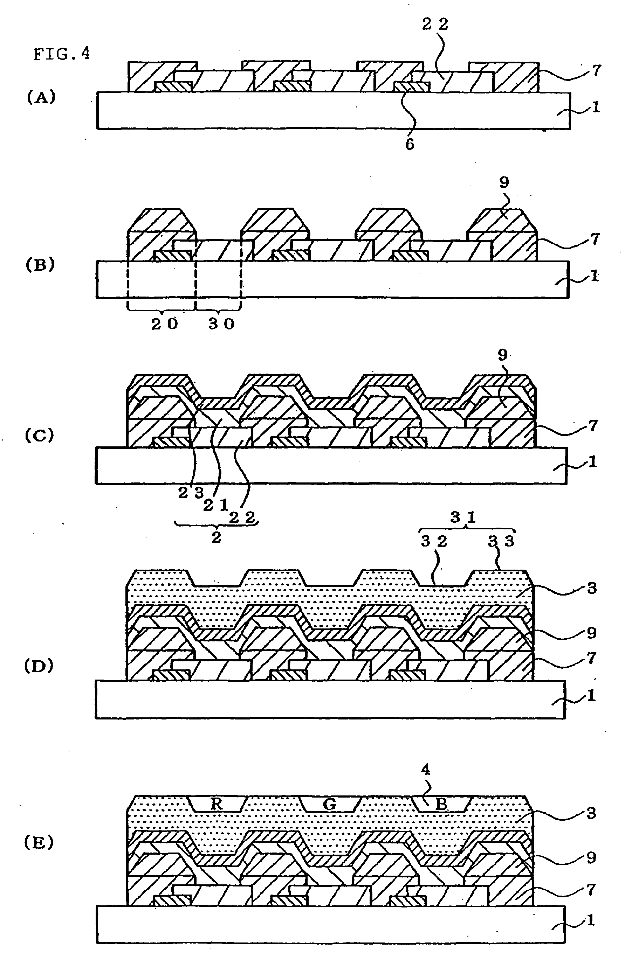

Next, a production method of the organic EL display of the second embodiment will be explained with reference to Fig. 4. The detail description on the same steps as the first embodiment is omitted.

According to the second embodiment, in the formation of an organic EL device, insulative members 7 are formed between under electrodes 22 (Fig. 4(A)) and thereafter rise members 9 are formed on at least part of the insulative members (Fig. 4(B)).

Next an organic luminescent medium 21 and upper electrode 23 are sequentially formed (Fig. 4(C)). The organic luminescent medium 21 and upper electrode 23 have a similar shape to that of the rise members 9 or they have convex parts just above the members 9. The organic EL device can be formed in such a way.

In the sealing step, a sealing layer 3 is formed similarly to the first embodiment (Fig. 4(D)). However convex parts 33 are formed on the surface 31 of sealing layer by the rise members 9. Concave parts 32 are defined by these convex parts 33 therebetween. Thus the concave parts 32 can be formed in the opening area 20 via which light emitted from the organic luminescent medium 21 passes.

The concave parts 32 can be easily formed at desired positions on the surface 31 by forming the rise members 9 at the desired positions.

Next in the step of forming a coloring layer, ink containing materials of the coloring layer is positioned in the concave parts 32 on the surface 31 by an ink-jet method to form the coloring layer 4 (Fig. 4(E)).

Ink is not flown out since ink is deposited in the concave parts 32 in the surface 31. As a result, the coloring layers 4 can be deposited at precise positions.

Ink can be precisely placed by printing methods such as an ink-jet method, thereby enabling the formation of a high precision pattern.

Further the coloring layers 4 can be formed without damaging the organic luminescent medium 21 because they are formed by applying ink.

Then a sealing substrate 5 is adhered in the same way as the first embodiment to produce an organic EL display.

The precise positioning of the supporting substrate 1 and sealing substrate 5 is not required at the time of adhering them since the coloring layers 4 are formed in the concave parts 32 on the supporting substrate 1 side. Thus even if the display is of top emission type, its production yield can be increased.

Further the display has excellent viewing angle properties since it does not have a flattening layer between the coloring layer 4 and organic EL device 2.

In this embodiment, a flattening layer is not formed. However a flattening layer may be formed at need, when the convex parts 33 of the sealing layer and coloring layer 4 do not form a plane.

Further the rise members 9 may be formed on the upper electrode 23 although they are formed on the insulative members 7 in this embodiment.

In order to form the concave parts, the rise members 9 are not necessarily required. The concave parts can be formed by the other methods. For example, part of the top surface of sealing layer may be selectively removed by etching and the like. A plane pattern may be used by which parts where coloring layers 4 are to be formed are surrounded in lattice (igeta) form.

### [Third Embodiment]

An organic EL display and its production method according to a third embodiment of the invention will be described with reference to drawings.

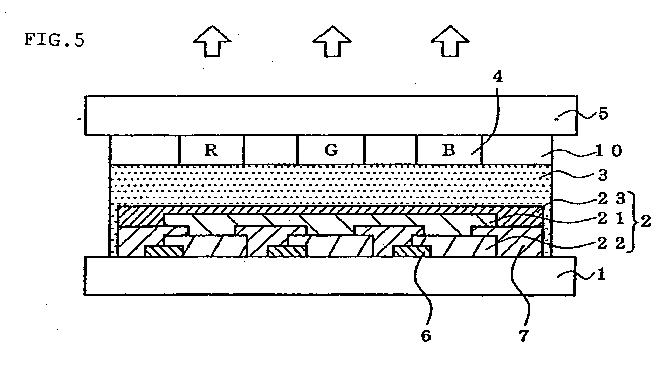

Fig. 5 is a diagram for explaining the structure of the organic EL display of the third embodiment. The same members as the first embodiment are denoted by the same reference numerals and their detail explanation is omitted.

In the third embodiment, part of the surface 31 of the sealing layer is not ink-repellent but an ink-receiving layer 10 is provided on a sealing layer 3 instead. Coloring layers 4 are provided at certain positions of the ink-receiving layer.

The ink-receiving layer is made of an ink-permeable resin and formed by printing, spin coating or applying. The layer has a thickness of about 0.5µm to about 20µm. Preferred resins include polyvinyl alcohols, celluloses and acrylate resins.

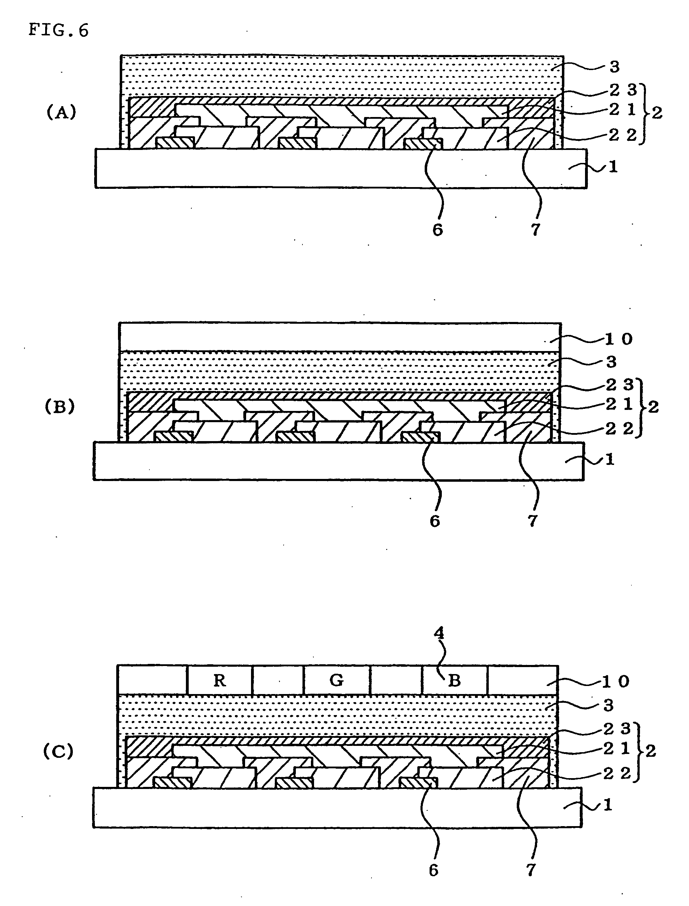

Next referring to Fig. 6, the method of producing the organic EL display according to the third embodiment will be explained. The detail description on the same steps as the first embodiment is omitted.

In this embodiment, a sealing layer 3 is formed (Fig. 6(A)) and then an ink-receiving layer 10 is formed on the sealing layer 3 (Fig. 6(B)).

Next, at the step of forming a coloring layer, ink containing materials of a coloring layer is penetrated at certain positions of the ink-receiving layer 10 by an ink jet method and the like to form the coloring layer 4 (Fig. 6(C)).

The solvent of the penetrated ink is evaporated to obtain the coloring layers at the certain positions. In addition it may be subjected to thermosetting for stabilization.

Ink can be precisely placed by printing methods such as an ink-jet method, thereby enabling the formation of a high precision pattern.

Further the coloring layers 4 can be formed without damaging the organic luminescent medium 21 because they are formed by applying ink.

Then a sealing substrate 5 is adhered in the same way as the first embodiment to produce an organic EL display.

The precise positioning of the supporting substrate 1 and sealing substrate 5 is not required at the time of adhering them since the coloring layers 4 are formed in the concave parts 32 on the supporting substrate 1 side. Thus even if the display is of top emission type, its production yield can be increased.

Further the display has excellent viewing angle properties since it does not have a flattening layer between the coloring layer 4 and organic EL device 2 and, the coloring layer 4 is not too away from the device 2.

### [Fourth Embodiment]

An organic EL display and its production method according to a fourth embodiment of the invention will be described with reference to drawings.

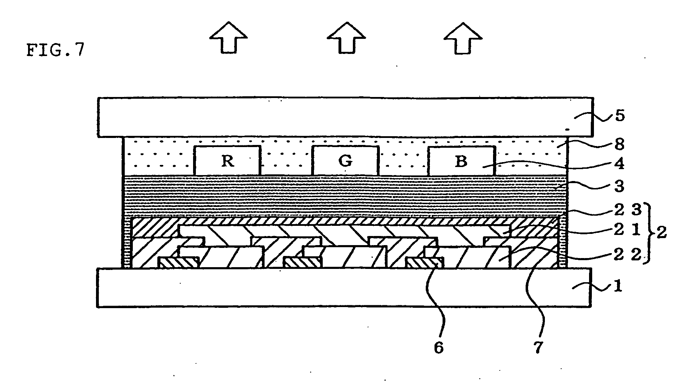

Fig. 7 is a diagram for explaining the structure of the organic EL display of the fourth embodiment. The same members as the first embodiment are denoted by the same reference numerals and their detail explanation is omitted.

In this embodiment, part of the surface 31 of the sealing layer is not ink-repellent but a sealing layer 3 contains an ultraviolet-ray shading material instead.

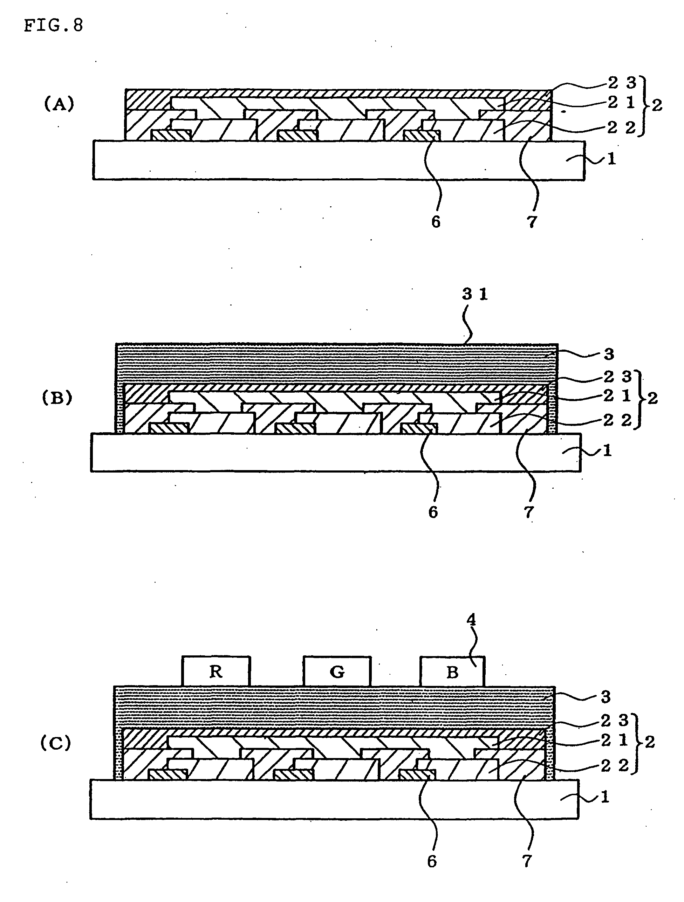

Next referring to Fig. 8, the method of producing the organic EL display according to the fourth embodiment will be explained. The detail description on the same steps as the first embodiment is omitted.

In this embodiment, an organic EL device 2 is formed (Fig. 8(A)) and a sealing layer 3 containing an ultraviolet-ray shading material is formed as a sealing layer 3 (Fig. 8(B)).

Materials shading ultraviolet rays include semiconductors with a large energy gap (2.8eV or more), which are transparent for visible light but absorb ultraviolet rays. There are preferably exemplified indium tin oxide (ITO), indium zinc oxide (IZO), zirconium oxide (ZnO), combinations thereof, and compounds obtained by adding Al, Si, Ta, Ti, Ga, Mg, Cd, Ge and so on to these oxides.

Further ultraviolet-ray absorbers are also preferably used that are obtained by adding In, Sn, Zn and so on to oxidized nitrides such as AlON, SiON, AlSiON, TiON and TaON, which are excellently moisture-proof.

In this embodiment, in the step of forming a coloring layer, a coloring layer 4 is formed by photolithography (Fig. 8(C)). The coloring layer 4 can be easily precisely formed by photolithography. Materials of the coloring layer used for photolithography are described later.

Generally photolithography is not used after the formation of an organic luminescent medium 21 since the organic luminescent medium 21 is liable to be damaged by ultraviolet rays. However in this embodiment, the damage that the organic luminescent medium 21 and the like receive can be reduced in the ultraviolet-ray photolithography since the sealing layer 3 shades ultraviolet rays. Therefore the coloring layer 4 can be easily formed at precise positions by ultraviolet-ray photolithography. If a solvent-proof layer such as oxidized nitrides is provided, damage from water and solvent can be prevented at the step of photolithography.

Further the sealing layer 3 does not necessarily contain an ultraviolet-ray shading material. For example an ultraviolet-ray reflecting multi-layer film (not shown) may be formed on the top surface of sealing layer instead.

A multi-layer film where high reflectance layers and low reflectance layers are alternately laminated is exemplified as an ultraviolet-ray reflecting multi-layer. Here "high reflectance" means a reflectance of 1.9 to 3.0, while "low reflectance" means a reflectance of 1.0 to 1.9. The film preferably has a thickness of one fourth of a wavelength of ultraviolet rays used in photolithography.

Ultraviolet rays can be reflected by such a multi-layer film at the time of ultraviolet-ray photolithography, thereby reducing the damage that organic luminescent medium 21 and the like receive.

Only ultraviolet rays can be easily selectively reflected while transmitting visible light by adjusting the film thickness and refraction index of the multi-layer film.

The similar advantageous effects can be obtained by applying a polymer containing an ultraviolet-ray absorber (not shown) to the top surface of a sealing layer.

There are exemplified polymers containing an ultraviolet-ray absorber such as triazole type absorbers and triazine type absorbers. The preferred film thickness is from about 0.5 to about 5µm.

Thereafter a flattening layer 8 is formed and a sealing substrate 5 is adhered in the same way as the first embodiment to produce an organic EL display as shown in Fig. 7.

The precise positioning of the supporting substrate 1 and sealing substrate 5 is not required at the time of adhering them to each other since the coloring layers 4 are formed at precise positions by photolithography on the supporting substrate 1 side. Thus even if the display is of top emission type, its production yield can be increased.

Further the display has excellent viewing angle properties since it does not have a flattening layer between the coloring layer 4 and organic EL device 2.

Although some structures of the invention have been explained in the above embodiments, various changes may be made. For example, although a display provided with TFTs has been described in the above embodiments, the invention can be preferably applied to a display with no TFTs.

Each of members constituting the displays of the embodiments will be explained. For members other than those described below, usual members can be used.

### 1. Supporting substrate

The support substrate 1 in the organic EL display is a member for supporting the organic EL device 2 and the like. Therefore the substrate is preferably excellent in mechanical strength and dimension stability.

Materials for such a substrate include glass plates, metal plates, ceramic plates and plastic plates such as polycarbonate resins, acrylic resins, vinyl chloride resins, polyethylene terephthalate resins, polyimide resins, polyester resins, epoxy resins, phenol resins, silicon resins and fluorine-containing resins.

In order to avoid the invasion of moisture into the organic EL display, the supporting substrate 1 made of these materials is preferably subjected to a moisture proof treatment or hydrophobic treatment by forming an inorganic film such as SiOx (0 < x ≦ 2), SiON, SiAlON or applying a fluorine-containing resin. The inorganic film is more preferably formed between the substrate 1 and the under electrode 22 and between the insulator 7 and the substrate 1.

In particular, in order to avoid the invasion of moisture into the organic luminescent medium 21, the supporting substrate 1 preferably has a small water content and gas permeability coefficient. Specifically, preferred water content and gas permeability coefficient are 0.0001% by weight or less and 1 × 10¹³ cc·cm/cm²·sec.cmHg or less, respectively.

In order to take out EL emission from the side opposite to the supporting substrate 1, that is, the upper electrode 23 side in the invention, the supporting substrate is not necessarily transparent.

### 2. Organic EL device

Generally the organic EL device 2 is constructed of the organic luminescent medium 21, the upper electrode 23 and the under electrode 22 which hold the medium therebetween. Each constituent element of the organic EL device 2, i.e. organic luminescent medium (1), upper electrode (2) and under electrode (3) will be sequentially described below.

### (1) Organic luminescent medium

The organic luminescent medium 21 can be defined as a medium containing an organic - luminescent layer wherein electrons and holes are recombined with each other, thereby allowing EL emission. This organic luminescent medium 21 can be made, for example, by laminating the following layers (a) to (g) on an anode:
(a) Organic luminescent layer
(b) Hole injecting layer/organic luminescent layer
(c) Organic luminescent layer/electron injecting layer
(d) Hole injecting layer/organic luminescent layer/electron injecting layer
(e) Organic semiconductor layer/organic luminescent layer
(f) Organic semiconductor layer/electron barrier layer/organic luminescent layer
(g) Hole injecting layer/organic luminescent layer/adhesion improving layer

Among these (a) to (g), the structure (d) is preferably used since it can give a higher luminescent brightness and is also superior in durability.

Constituent materials (a) and thickness (b) of the organic luminescent medium will be sequentially described below.

### (a) Constituent materials of the organic luminescent medium

An organic luminescent layer (i), hole injecting layer (ii), electron injecting layer (iii) and adhesion improving layer (iv) will be sequentially described as examples of members constituting the organic luminescent medium 21.

### (i) Organic luminescent layer

Examples of luminous materials of the organic luminescent layer in the organic luminescent medium 21 include only one or combinations of two or more selected from p-quaterphenyl derivatives, p-quinquephenyl derivatives, benzothiazole compounds, benzimidazole compounds, benzoxazole compounds, metal-chelated oxynoid compounds, oxadiazole compounds, styrylbenzene compounds, distyrylpyrazine derivatives, butadiene compounds, naphthalimide compounds, perylene derivatives, aldazine derivatives, pyraziline derivatives, cyclopentadiene derivatives, pyrrolopyrrole derivatives, styrylamine derivatives, coumarin compounds, aromatic dimethylidyne compounds, metal complexes having an 8-quinolinol derivative as a ligand, and polyphenyl compounds.

Among these organic luminous materials, preferable are aromatic dimethylidyne compounds. For example, 4,4'-bis(2,2-di-t-butylphenylvinyl)biphenyl (abbreviated to DTBPBBi), 4,4'-bis(2,2-diphenylvinyl)biphenyl (abbreviated to DPVBi), and derivatives thereof are more preferable.

Furthermore, it is preferred to use together a material where an organic luminescent material having a distyrylarylene skeleton or the like, as a host material, is doped with a fluorescent dye giving intense from blue to red fluorescence, for example, a coumarin material, or a styrylamine fluorescent dye, as a dopant. More specifically, it is preferred to use the above-mentioned DPVBi or the like as a host and N,N-diphenylaminostyrylbenzene (abbreviated to DPAVB) as a dopant.

### (ii) Hole injecting layer

Compounds having a hole mobility of 1 x 10⁻⁶ cm²/v·s or more measured at an applied voltage of 1 x 10⁴ to 1 x 10⁶ V/cm and an ionization energy of 5.5 eV or less are preferably used in a hole injecting layer of the organic luminescence medium 21. Such a hole injecting layer enables good hole injection into an organic emitting layer, thereby enhancing a luminescence brightness or allowing low voltage drive.

Examples of a constituent material for the hole injection layer include porphyrin compounds, aromatic tertiary amine compounds, stilamine compounds, aromatic dimethylidine compounds, condensed aromatic ring compounds and organic compounds such as 4,4-bis[N-(1-naphthyl)-N-phenylamino]biphenyl (NPD) and 4,4',4"-tris[N-(3-methylphenyl)-N-phenylamino]triphenylamine (MTDATA).

Inorganic compounds such as p-type Si and P-type SiC are preferably used as a constituent material for the hole injection layer.

It is also preferred that an organic semiconductive layer having an electrical conductivity of 1 x 10⁻¹⁰ S/cm or more is formed between the above hole injecting layer and an anode, or between the above hole injecting layer and an organic emitting layer. Such an organic semiconductive layer enables better hole injection into an organic emitting layer.

### (iii) Electron injecting layer

Compounds having an electron mobility of 1 x 10⁻⁶ cm²/v·s or more measured at an applied voltage of 1 x 10⁴ to 1 x 10⁶ V/cm and an ionization energy more than 5.5 eV are preferably used in an electron injecting layer in the organic luminescence medium 21. Such an electron injecting layer enables good electron injection into an organic emitting layer, thereby enhancing a luminescence brightness or allowing low voltage drive.

Examples of a constituent material for the electron injecting layer include 8-hydroxyxinoline metal complexes such as Al chelate: Alq, derivatives thereof or oxadiazole derivatives.

### (iv) Adhesion improving layer

An adhesion improving layer of the organic luminescence layer 21 is a form of the electron injecting layer. That is, it is a special layer comprising a material with good adhesion properties to a cathode among electron injecting layers. The adhesion improving layer is preferably made of a material such as 8-hydroxyxinoline metal complexes or derivatives thereof.

It is also preferred that an organic semiconductor layer with an electric conductivity of 1 x 10⁻¹⁰ S/cm or more is formed in contact with the above electron injecting layer. Such an organic semiconductor layer enables good electron injecting into an organic emitting layer.

### (b) Thickness of the organic luminescent medium

The thickness of the organic luminescent medium 21 is not particularly limited. However it is preferably in the range of, for example, 5nm to 5µm. If the thickness is below 5nm, the luminescent brightness and durability thereof may deteriorate, while if it is over 5µm, the value of the voltage to be applied may become high. Therefore, the thickness of the organic luminescent medium 21 is more preferably 10nm to 3µm, and still more preferably 20nm to 1µm.

### (2) Upper electrode

In the embodiments, the upper electrode 23 is arranged over entire the surface of display area.

The upper electrode 23 corresponds to an anode or a cathode layer dependently on the structure of the organic EL device 2. In the case that the upper electrode corresponds to an anode layer, it is preferred to use a material having a large work function, for example, 4.0 eV or more, in order to make hole-injection easy. In the case that the upper electrode corresponds to a cathode layer, it is preferred to use a material having a work function of less than 4.0 eV in order to make electron-injection easy.

In organic EL displays of top emission type, it is necessary for the upper electrode 23 to have transparency in order to get light out through the upper electrode 23. Accordingly, in the case that the upper electrode 23 corresponds to the anode layer, materials for the upper electrode include only one or combinations of two or more selected from indium tin oxide (ITO), indium zinc oxide (IZO), copper indium oxide (CuInO), tin oxide (SnO₂), zinc oxide (ZnO), antimony oxide (Sb₂O₃, Sb₂O₄, Sb₂O₅), aluminum oxide (Al₂O₃) and so on.

In order to decrease the resistance of the upper electrode 23 without damaging transparency, a layer made of only one or combination of two or more selected from metals such as Pt, Au, Ni, Mo, W, Cr, Ta and Al is preferably formed around a pixel of the upper electrode.

The upper electrode 23 can be made of at least one material selected from the group containing light transmitting metal films, nondegenerate semiconductors, organic conductors and semiconductive carbon compounds. Preferred organic conductors include conductive conjugated polymers, oxidizer-added polymers, reducer-added polymers, oxidizer-added low molecules or reducer-added low molecules.

Examples of oxidizers added to an organic conductor include Lewis acids such as iron chloride, antimony chloride and aluminum chloride. Further Examples of reducers added to an organic conductor include alkali metals, alkali-earth metals, rare-earth metals, alkali compounds, alkali-earth compounds or rare-earth compounds. Examples of conductive conjugated polymers include polyanilines and derivatives thereof, polytiophens and derivatives thereof and Lewis-acid-added amine compounds.

Preferred examples of nondegenerate semiconductors include oxides, nitrides or chalcogenide compounds.

Preferred examples of carbon compounds include amorphous C, graphite or diamond like C.

Examples of inorganic semiconductors include ZnS, ZnSe, ZnSSe, MgS, MgSSe, CdS, CdSe, CdTe or CdSSe.

The thickness of the upper electrode 23 is decided preferably its sheet resistance or the like. For example, the thickness of the upper electrode 23 is preferably in the range of 50nm to 5000nm, more preferably 100nm or more. Such a thickness allows a uniform thickness distribution and light transmission of 60% or more of EL emission as well as a sheet resistance of the upper electrode 23 of 15Ω/□ or less, more preferably 10Ω/□ or less.

### (3) Under electrode

In the embodiments, the under electrode 22 is individually separatively arranged per pixel in a plane pattern.

The under electrode 22 corresponds to an anode or cathode layer dependently on the structure of the organic EL display. In the case that the under electrode corresponds to a cathode layer, it is preferred to use a material having a smaller work function, for example, a metal, an alloy, an electrically conductive compound, a mixture thereof or a material containing at least one of them having a work function of less than 4.0 eV.

As such materials, for example, it is preferred to use one or a combination of two or more selected from sodium, sodium-potassium alloys, cesium, magnesium, lithium, magnesium-silver alloys, aluminum, aluminum oxide, aluminum-lithium alloys, indium, rare earth metals, mixtures of these metals and organic luminescence medium materials, mixtures of these metals and electron injecting layer materials, and so on.

In the invention, it is not necessary for materials of the under electrode 22 to have transparency since luminescence is got from the upper electrode 23 side. It is preferably made rather from light-absorbing conductive materials. This structure enhances the display contrast of organic EL display. In this case, preferable light-absorbing conductive materials include semiconductive carbonate materials, colored organic compounds, combinations of the above reducers and oxidizers, and colored conductive oxide (transition metal oxides such as VOx, MoOx, WOx and etc.).

The thickness of the under electrode 22 is not particularly limited as well as the upper electrode 23. However, it is preferably in the range of, for example, 10nm to 1000nm, more preferably 10nm to 200nm.

### 3. Insulative member

The insulative member 7 (electric insulator) in the organic EL display of the embodiments is formed near or around the organic EL device 2. The insulative member 7 is used for high resolution of a whole organic EL display, and for prevention of short circuits between the under and upper electrodes 22, 23. In the case that the organic EL device 2 is driven by the TFTs 6, the insulative member 7 is also used for protection of the TFTs 6 and as a base for coating of the under electrode 22 of the organic EL device 2 flatly.

Therefore, the insulative member 7 may be called, a partition, a spacer, a rib, a flattening film or the like if necessary. The invention embraces all of them.

In the embodiments the insulative members 7 are provided to bury gaps between the under electrodes formed separately disposed per pixel. That is, the insulative members 7 are disposed along boundaries between pixels.

Examples of materials for the insulative member 7 usually include acrylic resins, polycarbonate resins, polyimide resins, fluorinated polyimide resins, benzoguanamine resins, melamine resins, cyclic polyolefins, Novolak resins, polyvinyl cinnamates, cyclic rubbers, polyvinyl chloride resins, polystyrenes, phenol resins, alkyd resins, epoxy resins, polyurethane resins, polyester resins, maleic acid resins, and polyamide resins.

In the case that the insulative member 7 is made of an inorganic oxide, preferred inorganic oxides include silicon oxide (SiO₂ or SiOₓ), aluminum oxide (Al₂O₃ or AlOₓ), titanium oxide (TiO₃ or TiOₓ), yttrium oxide (Y₂O₃ or YOₓ), germanium oxide (GeO₂ or GeOₓ), zinc oxide (ZnO), magnesium oxide (MgO), calcium oxide (CaO), boric acid (B₂O₃), strontium oxide (SrO), barium oxide (BaO), lead oxide (PbO), zirconia (ZrO₂), sodium oxide (Na₂O), lithium oxide (Li₂O), potassium oxide (K₂O) and combinations thereof.

The value x in the above inorganic compounds is in the range of 1 ≤ x ≤ 3.

In the case that heat-resistance is required for the member 7, it is preferred to use acrylic resins, polyimide resins, fluorinated polyimides, cyclic olefins, epoxy resins, or inorganic oxides.

These insulative members 7, when being organic, can be worked into a desired pattern by introducing a photosensitive group thereto and using a photolithography method, or can be formed into a desired pattern by printing.

The thickness of the insulative member 7 depends on the minuteness of display, or unevenness of other members combined with the organic EL device, and is preferably 10 nm to 1 mm. This is because such a structure makes it possible to make the unevenness of the TFTs and the like sufficiently flat.

Accordingly, the thickness of the insulative member 7 is more preferably 100 nm to 100 µm, and still more preferably 100 nm to 10 µm.

### 4. Thin film transistor (TFT)

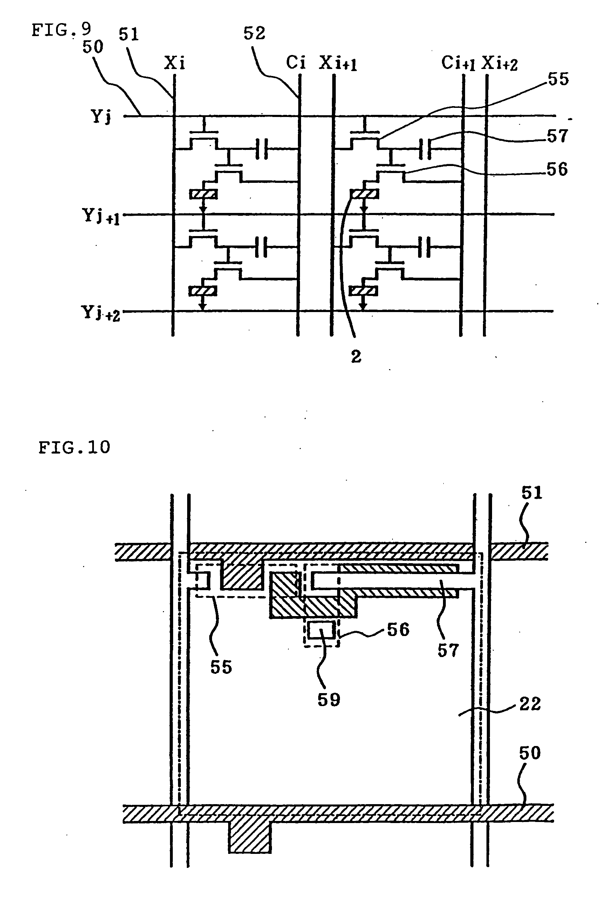

Fig. 9 is a circuit diagram showing the connection structure of electric switches with TFTs. Fig. 10 is a plane view showing the connection structure of electric switches with TFTs.

As shown in Fig. 9, scanning electrode lines (Yj-Yj+n) 50 and signal electrode lines (Xi-Xi+n) 51 are arranged in an XY matrix. The number n of lines is, for example, 1 to 1,000. They are electrically connected to the TFTs 6. Furthermore, common electrode lines (Ci-Ci+n) 52 are electrically connected to the TFTs 6 in parallel to the signal electrode lines 51.

It is preferred that these electrode lines 50, 51 and 52 are electrically connected to the TFTs 6 and they, together with a capacitor 57, constitute an electric switch for driving the organic EL device 2. Specifically, it is preferred that an electric switch is electrically connected to a scanning electrode line, a signal electrode line and the like, and comprises, for example, at least one first transistor (which may be referred to as Tr1 hereinafter) 55, a second transistor (which may be referred to as Tr2 hereinafter) 56, and a capacitor 57.

It is preferred that the first transistor 55 has a function for selecting a luminous pixel and the second transistor 56 has a function for driving the organic EL device.

Active layers in the first transistor (Tr1) 55 and the second transistor (Tr2) 56 are constructed of semiconductor regions doped into the n type and a non-doped semiconductor region, which is represented as n+/i/n+.

The semiconductor regions doped into the n type are a source and a drain, respectively. They, together with a gate deposited above the non-doped semiconductor region with a gate oxide film there between constitute the transistors 55 and 56.

In the active layer, the semiconductor regions doped into the n type may be doped into the p type, instead of the n type, so as to make a structure of p+/i/p+. The active layers in the first transistor (Tr1) 55 and the second transistor (Tr2) 56 are preferably made of an inorganic semiconductor such as polysilicon or an organic semiconductor such as thiophene oligomers or poly(P-phenylenevinylene). Polysilicon is a particularly preferred material since it is far more stable against electricity than amorphous Si (α-Si).

A drain of TFT 6 is electrically connected to an under electrode 22 of organic EL device 2 through a contact hole provided in an insulative member 7. The contact hole is formed of a conductive inorganic oxide.

As shown in the circuit diagram of Fig. 9, it is preferred that a TFT 6 contains first and second transistors (Tr1) 55 and (Tr2) 56 and constitutes an electric switch.

In such structure of electric switch, a scanning pulse and a signal pulse are inputted through electrodes of the XY matrix so that switch operation is performed, thereby driving an organic EL device 2.

Specifically light emission is generated or stopped from the organic EL device 2 by the electric switch so that an image can be displayed.

When driving an organic EL device 2 by an electric switch in such a way, a desired first transistor 55 is selected by a scanning pulse transmitted through a scanning electrode line (which may be referred to as a gate line) (Yj-Yj+n) 50 and a scanning pulse transmitted through a signal electrode line (Xi-Xi+n) 51 to supply given electrical charges to the capacitor 57 formed between the common electrode line (Ci-Ci+n) 52 and the source of the first transistor (Tr1) 55.

As a result, the gate voltage of the second transistor (Tr2) 56 turns into a constant value and the second transistor (Tr2) 56 turns into an ON state. Since in this ON state the gate voltage is held until a next gate pulse is transmitted, electric current continues to be supplied to the under electrode 22 connected to the drain of the second transistor (Tr2) 56.

An organic EL device 2 can be driven by supplied current, enabling significant decrease in driving voltage for the organic EL device 2, improvement of the luminous efficiency thereof with a reduced power consumption.

### 5. Sealing layer

Examples of materials for the sealing layer 3 include transparent resins, sealing liquids and transparent inorganic materials.

Examples of transparent resins which can be used as a constituent material for the sealing layer 3 include polyphenyl methacrylate, polyethylene terephthalate, poly-o-chlorostyrene, poly-o-naphthyl methacrylate, polyvinyl naphthalene, polyvinyl carbazole and polyester containing fluorene skeleton.

In case of using a transparent resin as a material for the sealing layer 3, it is preferably to comprise ultraviolet-ray curing resins, visible light curing resins, thermosetting resins or adhesives using them. Specific examples thereof include commercially available products such as Luxtrak LCR0278, 0242D (both of which are made by Toagosei Co., Ltd.), TB3102 (epoxy type, made by Three Bond Co., Ltd.)and Venefix VL (acrylic type, made by Adel Co., Ltd.).

Examples of transparent inorganic materials which can be used as a material'constituting the sealing layer 3 include SiO₂, SiOₓ, SiOₓN_{y}, Si₃N₄, Al₂O₃, AlOₓN_{y}, TiO₂, TiOₓ, SiAlOₓN_{y}, TiAlOₓ, TiAlOₓN_{y}, SiTiOₓ and SiTiOₓN_{y}.

In the case of using a transparent inorganic material for the sealing layer 3, the film is preferably formed at a low temperature (100°C or lower) and a slow film-forming speed in order that the organic EL device 2 is not deteriorated. Specifically, methods such as sputtering, vapor deposition or CVD is preferred.

These transparent inorganic materials are preferably amorphous since the amorphous films have a high effect of shielding moisture, oxygen, low molecular monomers and so on and suppress the deterioration of the organic EL device 2.

Examples of a sealing liquid constituting the sealing layer 3 include fluorinated hydrocarbons and fluorinated olefine oligomers.

An aromatic ring containing compound, a fluorine skeleton containing compound, a bromine containing compound, or a sulfur containing compound, and compounds having a high refractive index, for example, metalic compounds such as alkoxytitanium (dimethoxytitanium, diethoxytitanium) and alkoxytitaniums may be added to adjust a refractive index.

The thickness of the sealing layer 3 is not particularly limited, and is preferably, for example, 10nm to 1mm.

If the thickness of the sealing layer 3 is less than 10nm, the transmitting amount of moisture and oxygen may increase, while if the thickness of the sealing layer 3 exceeds 1mm, a grooved form may not be provided because of the increased whole thickness.

For such a reason it is more preferred that the thickness of the sealing layer 3 is 10nm to 100µm.

### 6. Coloring layer

The coloring layer 4 of the invention contains the following three cases: (i) single color filter, (ii) single fluorescent medium and (iii) combination of a color filter and a fluorescent medium.

Among above (i) to (iii), the combination of a color filter and a fluorescent medium (iii) is very preferably because of improving the brightness despite low-power and the balance of display colors at the time of emitting each of three primary colors.

For example, when the organic EL device 2 emits blue light, a blue pixel has only a blue color filter, a green pixel has a fluorescent medium converting blue light to green light and a green color filter, and a red pixel has a fluorescent medium converting blue light to red and a red color filter.

The follow will describe the constitution of a color filter and a fluorescent medium or the like.

### (i) Color filter

The color filter is to decompose or cut light to adjust color or improve contrast.

Examples of materials for the color filter include the following dyes or solid objects in which the same dye is dissolved or dispersed in a binder resin.

### Red (R) dye:

It is possible to use only one or a mixture of at least two and more selected from Perylene pigments, lake pigments, azoic pigments, quinacridone pigments, anthraquinone pigments, anthracene pigments, isoindorine pigments, isoindorinone pigments and so on.

### Green (G) dye:

It is possible to use only one or a mixture of at least two and more selected from halogen-multisubstituted phthalocyanine pigments, halogen-multisubstituted copper phthalocyanine dyes, triphenylmethane basic dyes, isoindorine pigments, isoindorinone pigments and so on.

### Blue (B) dye:

It is possible to use only one or a mixture of at least two and more selected from copper - phthalocyanine dyes, indanthrone pigments, indophenol pigments, cyanine pigments and dioxazin pigments and so on.

The binder resin for color filters is preferably a material having transparency (transmittance in the visible light region: 50% or more). Examples thereof are transparent resins (polymers) such as polymethyl methacrylate, polyacrylate, polycarbonate, polyvinyl alcohol, polyvinyl pyrrolidone, hydroxyethylcellulose, and carboxymethylcellulose. It can be used as one or a mixture of two or more thereof.

In the case that the color filter is formed by a printing method such an ink-jet method, a printing ink (medium) using a transparent resin can be used. For example, one or two or more can be selected from transparent resins such as polyvinyl chloride resins, polyvinylidene chloride resins, melamine resins, phenol resins, alkyd resins, epoxy resins, polyurethane resins, polyester resins, maleic acid resins, compositions of monomers, oligomers and polymers of polyamide resins, polymethyl methacrylate, polyacrylate, polycarbonate, polyvinyl alcohol, polyvinyl pyrrolidone, hydroxyethylcellulose or carboxymethylsellulose.

If necessary, a liquid solvent can be used. Examples thereof include water, alcohols such as methanol, ethanol, isopropanol or mixtures thereof.

The concentration of dyes, resins and liquid solvents can be properly selected in the view of the function of coloring layers and application to ink-jet method. Preferably a dye concentration is 0.1 to 3% by weight and a resin concentration is 2 to 50% by weight.

When photolithography is used for the formation of the color filter, a photosensitive resin can be preferably applied. Examples thereof are photosetting resist materials having reactive vinyl groups such as acrylic acid type, methacrylic acid type, polyvinyl cinnamate type and cyclic rubber type. A mixture of one or two and more thereof can be used.

In the case that the fluorescent medium is made of a fluorescent dye and such a resin, the fluorescent medium is preferably formed by mixing, dispersing or dissolving the fluorescent dye and the resin with an appropriate solvent to prepare a liquid material; making the liquid material into a film by spin coating, roll coating, casting or the like; and subsequently patterning the film into a desired pattern by photolithography or screen printing or the like.

The thickness of the color filter is not particularly limited. For example, the thickness is preferably 10nm to 1,000µm, more preferably 0.5µm to 500µm, and still more preferably 1µm to 100µm.

### (ii) Fluorescent medium

The fluorescent medium has a function of absorbing luminescence of the organic EL device 2 to give fluorescence having a longer wavelength.

Each of the fluorescent mediums is preferably arranged correspondingly to the emitting area of the organic EL device 2, for example, the position where the upper electrode 23 and the under electrode 22 cross each other. If the organic emitting layer at the intersections of the upper electrode 23 and the under electrode 22 emits light, the respective fluorescent medium layer receives the light to emit light having a different color (wavelength), which can be taken out.

The constituent material of the fluorescent medium is not particularly limited and is made of, for example, a fluorescent dye and a resin, or only a fluorescent dye. The fluorescent dye and the resin may be solid where a fluorescent dye is dissolved or dispersed in a pigment resin and/or a binder resin.

Specific examples of the fluorescent dye will be described. Examples of a fluorescent dye for changing near-ultraviolet to violet light emitted from the organic EL device 2 to blue light include stylbene dyes such as 1,4-bis(2-methylstyryl)benzene (Bis-MBS) and trans-4,4'-diphenylstylbene (DPS); and coumarin dyes such as 7-hydroxy-4-methylcoumarin (coumarin 4).

Examples of a fluorescent dye for changing blue, bluish green or white light emitted from the organic EL device 2 to green light include coumarin dyes such as 2,3,5,6-1H,4H-tetrahydro-8-trifluoromethyl quinolidino(9,9a,1-gh)coumarin (coumarin 153), 3-(2'-benzothiazolyl)-7-diethylaminocoumarin (coumarin 6) and 3-(2'-benzimidazolyl)-7-N,N-diethylaminocoumarin (coumarin 7); Basic Yellow 51, which is a coumarin type dye; and naphthalimide dyes such as Solvent Yellow 11 and Solvent Yellow 116.

Examples of a fluorescent dye for changing blue to green light or white light emitted from the organic EL device 2 to orange to red light include cyanine dyes such as 4-dicyanomethylene-2-methyl-6-(p-dimethylaminostyryl)-4H-pyran (DCM); pyridine dyes such as 1-ethyl-2-(4-(p-dimethylaminophenyl)-1,3-butadienyl)-pyridinium-perchlorate (pyridine 1); rhodamine dyes such as Rhodamine B and Rhodamine 6G; and oxadine dyes.

Various dyes (direct dyes, acidic dyes, basic dyes, disperse dyes and so on) can be selected as fluorescent dyes if they have fluorescent properties.

The fluorescent dye that has been beforehand kneaded into a pigment resin may be used. Such pigment resins include polymethacrylic acid esters, polyvinyl chlorides, vinyl chloride vinyl acetate copolymers, alkyd resins, aromatic sulfonamide resins, urea resins, melamine resins and benzoguanamine resins.

The same binder resins for the color filter can be used here.

The same forming methods for the color filter can be used for the fluorescent medium.

The thickness of the fluorescent medium is not particularly limited. For example, the thickness is preferably 10nm to 1,000µm, more preferably 0.1µm to 500µm, and still more preferably 5µm to 100µm.

### 7. Flattening layer

Explanation about a flattening layer 8 is similar to that for the sealing layer 3.

### 8. Sealing substrate

In order to prevent moisture from invading the inside of the organic luminescent medium, it is preferred that the sealing substrate 5 covers at least the emitting area of the organic EL display.

As such a sealing substrate 5, the same materials for the supporting substrate 1 can be used. In particular, a glass plate or a ceramic substrate having a high effect of shielding moisture or oxygen can be used. The form of the sealing substrate 5 is not particularly limited, but preferably, for example, a plate or a cap. For example, in the case of a plate form, the thickness thereof is preferably in the range of 0.01 to 5mm.

It is also preferred that the sealing substrate 5 is fitted into a groove or the like made in a part of the supporting substrate 1 under pressure and then fixed thereto, or that the sealing member is fixed to a part of the supporting substrate 1 with a photo-curing adhesive agent or the like.

### Examples

### [Example 1]

### 1. Formation of TFT substrate

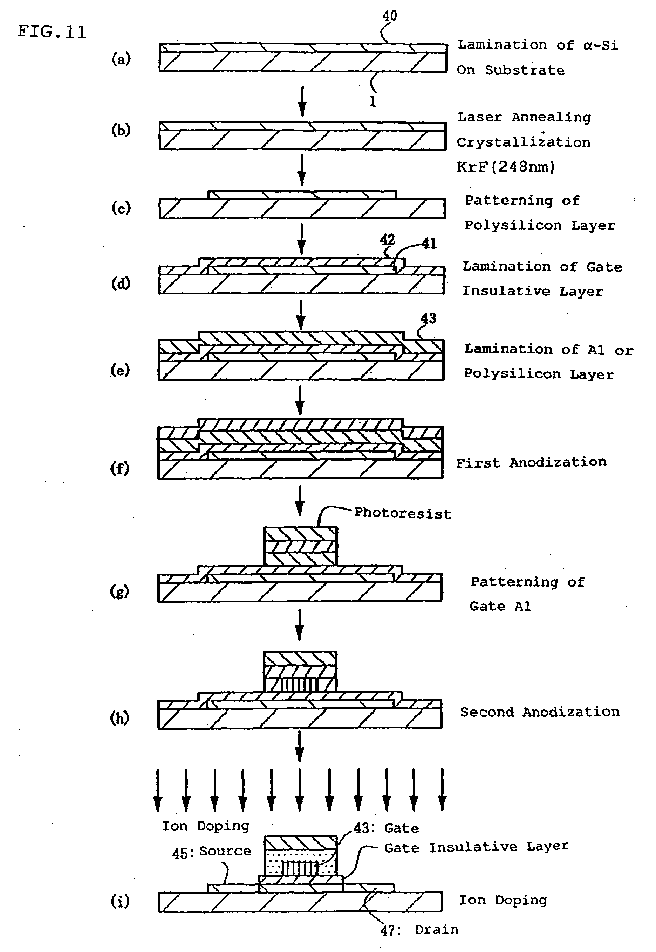

Figs. 11 (a) to (i) are views showing the steps of forming a polysilicon TFT. The circuit diagram showing the connection structure of electric switch with the polysilicon TFT is similar to Fig. 9, while a plane view thereof is also similar to Fig. 10.

Firstly an α-Si layer 40 was laminated on a glass substrate 1 of 112mm x 143mm x 1.1mm (OA2 glass, Nippon Electric Glass Co., Ltd.) by low pressure chemical vapor deposition (LPCVD) and the like (Fig. 11 (a)). Next the α-Si layer 40 was irradiated with an excimer laser such as a KrF (248nm) laser to be subjected to annealing crystallization, thereby converting α-Si to polysilicon (Fig. 11 (b)). This polysilicon was patterned into an island form by photolithography (Fig. 11 (c)). An insulative gate material 42 was laminated on the island-like polysilicon 41 and the surface of the substrate 1 by chemical vapor deposition (CVD) and the like to form a gate oxide insulative layer 42 (Fig. 11 (d)). A gate electrode 43 was then formed as a film by depositing or sputtering (Fig. 11 (e)), and patterned with anodization (Figs. 11 (f) to (h)). Further doping regions were formed by ion doping (ion implantation), thereby forming active layers as a source 45 and a drain 47 to obtain a polysilicon TFT (Fig. 11 (i)). At this time, the gate electrode 43 (and a scanning electrode 50 and a bottom electrode of a capacitor 57 shown in Fig. 10) was Al, while the source 45 and drain 47 of TFT were of n+ type.

Next a 500nm-thick inter-insulator (SiO₂) was formed on the active layers by CRCVD. Thereafter signal electrode lines 51, common electrode lines 52 and top electrodes (Al) of capacitors were formed. The source electrodes of second transistors (Tr2) 56 were connected to the common electrodes. The drains of first transistors (Tr1) 55 were connected to the signal electrodes. Refer to Figs. 9 and 10. Each TFT was connected to each electrode by properly opening the inter-insulator SiO₂ by wet etching with hydrofluoric acid.

Then Cr and ITO films were sequentially deposited by sputtering in thicknesses of 2000Å and 1300Å, respectively. A positive resist (HPR204, FUJIFILM Arch Co., Ltd.) was applied on the substrate by spin coating. The resultant substrate was exposed to ultraviolet rays with a photo mask of 90µm x 320µm for a dot pattern, subjected to development with a developing liquid of TMAH (tetramethy ammonium hydroxide) and baked at 130°C to obtain a resist pattern.

Next ITO in the exposed parts was etched by an ITO etchant of 47% hydrobromic acid and then Cr was etched by cerium nitrate ammonium/perchloric acid aqueous solution (HCE: NAGASE & Co., Ltd.). The resist was processed by a release liquid mainly containing ethanolamine (N303: NAGASE & Co., Ltd.) to produce a Cr/ITO pattern (under electrode: anode).

At this time, Tr2 56 was connected to the under electrode 22 via an opening 59 (Fig. 10).

As a second inter-insulative film, a negative resist (V259BK: Nippon Steel Chemical Co., Ltd.) was applied by spin coating, exposed to ultraviolet rays and developed by a TMAH (tetramethyl ammonium hydroxide) developer. The obtained film was baked at 180°C to produce an organic inter-insulative film coating Cr/ITO edges (the opened part of ITO was 70µm x 200µm) (not shown).

### 2. Formation of organic EL device

The substrate with the inter-insulative film thus obtained was subjected to ultrasonic cleaning with purified water and isopropyl alcohol, dried with air blow and thereafter cleaned with ultraviolet rays.

The TFT substrate was moved into an organic deposition device (ULVAC Co., Ltd.) and fixed in a substrate holder. A resistance-heating board made of molybdenum was filled with 200mg of N,N'-diphenyl-N,N'-bis(3-methylphenyl)-[1,1'-biphenyl]-4,4'-diamine(TPD), another resistance-heating board made of molybdenum was filled with 200mg of 4,4'-bis(2,2'-diphenylvynyl)biphenyl(DPVBi), and another resistance-heating board made of molybdenum was filled with the compound (A) shown below. The pressure of a vacuum vessel was reduced to 1 x 10⁻⁴ Pa. Thereafter the board with TPD was heated to 215 to 220°C and TPD was deposited on a transparent supporting substrate at a depositing rate of 0.1 to 0.3 nm/second to form a 60nm-thick hole injecting transporting layer. At this time the substrate temperature was room temperature. Next the resultant substrate was not taken out and the board with DPVBi was heated and DPVBi was deposited and laminated in a thickness of 40nm on the hole injecting transporting layer as a first emitting layer. At this time, the board with the compound (A) was simultaneously heated so that the first emitting layer contained the compound (A) at a ratio of 3.0 mole%. The vacuum vessel was then returned to atmospheric pressure. A resistance-heating board made of molybdenum was newly filled with 200mg of 8-hydroxy-quinoline/aluminum complex (Alq) and anther resistance-heating board made of molybdenum was filled with Rubrene (Aldrich Co.). The pressure of vacuum vessel was reduced to 1 x 10⁻⁴ Pa again. Next the board with Alq was heated and a 20nm-thick film was formed as a second emitting later. At this time, the board with Rubrene was simultaneously heated so that the second emitting layer contained Rubrene at a ratio of 0.5 mole%.

Next the substrate was moved in a sputtering vessel. An IZO film was formed at a depositing rate of 0.1 to 0.3 nm/second in a thickness of 200nm as an under electrode to obtain an organic EL device.

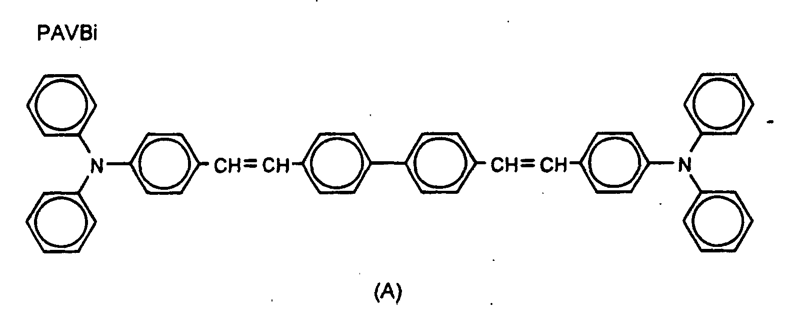

### 3. Formation of sealing layer

As a sealing layer, SiOₓN_{y} (O/O+N=50%: atomic ratio) was deposited by low temperature CVD to form a 1µm-thick transparent inorganic film on the upper electrode of the organic EL device. An organic EL device substrate was thus obtained.

### 4. Ink-repellency to surface of sealing layer

To the sealing layer of the above organic EL device substrate was adhered a mask with a 90µm opening and 240µm gap and the substrate was mounted in a low plasma discharge device. A He mixed gas containing 2.65 vol.% of SF4 was introduced into the low plasma discharge device and a discharge processing was performed under conditions of 2900 Hz and 8 mA at atmospheric pressure for 1 minute. After the discharge processing, the mask was removed and the water contact angle of the part corresponding to an opening was measured to be 110 °.

### 5. Preparation of color filter ink

Weight ratio: ethylene glycol 10%; diethylene glycol 15%; R, G and B pigments 4%; 0.6% monoethanolamine salt of a stylene-maleic acid resin (average molecular 30,000, acid value 300);-and water 70.4%
Red pigment: a mixed pigment of C.I. pigment red 168 and C.I. pigment orange 36 at a weight ratio of 23:8
Green pigment: a mixed pigment of C.I. pigment green 36 and C.I. pigment yellow 83 at a weight ratio of 15:4
Blue pigment: a mixed pigment of C.I. pigment blue 60 and C.I. pigment violet 23 at a weight ratio of 9:3

The above pigments were dispersed by a sand mill so that particles with a diameter of 0.01 to 0.4µm occupied about 90% of all the particles and filtered with a 1µm filter. Then the pigments thus pre-treated were used.

### 6. Lamination of color filter

Ink dots of R, G and B three colors were formed by an ink-jet recording device that can foam and jett ink by thermal energy using ink of the following composition. Further they were dried at 80°C for 20 minutes and then at 180°C for 1 hour to form pigment particle layers. The layers had a thickness of 0.4µm. Next an acrylic thermosetting resin (V259PH: Nippon Steel Chemical Co., Ltd.) was spin-coated on the color layer, as a transparent protecting film on the pigment particle layers of R, G and B three colors, and baked at 180°C to form a flattening layer with a thickness of 12µm, thus obtaining an organic EL display.

### 7. Properties of organic EL display

Upon applying a voltage of DC 9.5 V between the under electrode (ITO/Cr) and upper electrode (IZO) of the display obtained (under electrode: (+), upper electrode: (-)), light was emitted at each intersection of the electrodes. These lights were looked as white as a whole. As a result of measurement by a chroma meter (CS100, MINOLUTA Co. Ltd.), the brightness was 23.7 cd/m² and CIE chromaticity coordinates were (0.28, 0.30). Even if the display screen was obliquely observed, excellent displaying propeties were confirmed without color bleeding.

### Industrial Applicability

As described in detail above, according to the invention, even if a display is of top emission type, a coloring layer can be precisely formed on a supporting substrate side without damaging an organic luminescent medium and the like. Therefore the precise positioning is not required when adhering a sealing substrate, thereby increasing a production yield.

In addition, since a coloring layer is provided directly on or near a sealing layer on the supporting substrate side, the distance between a luminescent medium and the coloring layer can be shortened in an organic EL device, even of top emission type. The viewing angle properties can be improved as a result.

## Claims

1. An organic electroluminescence display comprising:
an organic electroluminescence device which emits light,
a sealing layer sealing the organic electroluminescence device, and
a coloring layer, formed on the sealing layer, which changes the light emitted from the organic electroluminescence device.

2. The organic electroluminescence display according to claim 1, wherein part of a surface contacting with the coloring layer of the sealing layer is repellent to ink and the coloring layer is formed on part other than the ink-repellent part.

3. An organic electroluminescence display comprising:
an organic electroluminescence device which emits light,
a sealing layer sealing the organic electroluminescence device, and
a coloring layer, formed on the sealing layer, which changes the light emitted from the organic electroluminescence device, the coloring layer being formed in concave parts of the sealing layer.

4. The organic electroluminescence display according to claim 3, wherein rise parts are provided inside the organic electroluminescence device in a non-opening area, and
the sealing layer has convex parts formed by the rise parts in the non-opening area, the concave parts being areas between the convex parts.

5. The organic electroluminescence display according to claim 3, wherein rise parts are provided on the organic electroluminescence device in a non-opening area, and
the sealing layer has convex parts formed by the rise parts in the non-opening area, the concave parts being areas between the convex parts.

6. An organic electroluminescence display comprising:
an organic electroluminescence device which emits light,
a sealing layer sealing the organic electroluminescence device, and
a coloring layer, formed on the sealing layer, which changes the light emitted from the organic electroluminescence device, the coloring layer being ink-permeable layers included in an ink-receiving layer formed on the sealing layer.

7. An organic electroluminescence display comprising:
an organic electroluminescence device which emits light,
a sealing layer sealing the organic electroluminescence device and containing an ultraviolet-ray shading material, and
a coloring layer, formed on the sealing layer, which changes the light emitted from the organic electroluminescence device.

8. An organic electroluminescence display comprising:
an organic electroluminescence device which emits light,
a sealing layer sealing the organic electroluminescence device,
an ultraviolet-ray reflecting multi-layer film formed on the sealing layer, and
a coloring layer, formed on the multi-layer film, which changes the light emitted from the organic electroluminescence device.

9. An organic electroluminescence display comprising:
an organic electroluminescence device which emits light,
a sealing layer sealing the organic electroluminescence device,
a polymer containing an ultraviolet-ray absorber, provided on the sealing layer, and
a coloring layer, formed on the polymer containing an ultraviolet-ray absorber, which changes the light emitted from the organic electroluminescence device.

10. The organic electroluminescence display according to claim 1, wherein the organic electroluminescence device, the sealing layer and the coloring layer are laminated on a supporting substrate in this order and further sealed.

11. A method for producing an organic electroluminescence display comprising:
forming an organic electroluminescence device which emits light,
forming a sealing layer sealing the organic electroluminescence device,
imparting ink-repellency to part of a surface of the sealing layer, and
applying ink on a surface of the sealing layer other than the ink-repellent part to form a coloring layer.

12. The method for producing an organic electroluminescence display according to claim 11, wherein ink-repellency is imparted by fluorine plasma treatment.

13. The method for producing an organic electroluminescence display according to claim 11, wherein ink-repellency is imparted by application of a fluorine polymer or a silicone polymer.

14. A method for producing an organic electroluminescence display comprising:
forming an organic electroluminescence device which emits light,
forming rise parts in a non-opening area on the organic electroluminescence device,
forming a sealing layer sealing the organic electroluminescence device on the rise parts, and
forming a coloring layer in concave parts of the sealing layer, the concave parts being defined between convex parts formed by the rise parts.

15. A method for producing an organic electroluminescence display comprising:
forming rise parts in a non-opening area above an under electrode,
forming an organic electroluminescence medium and an upper electrode on the rise parts to form an organic electroluminescence device with the organic luminescence medium held between the under and the upper electrodes,
forming a sealing layer sealing the organic electroluminescence device thereon, and
forming a coloring layer in concave parts of the sealing layer, the concave parts being defined between convex parts formed by the rise parts.

16. A method for producing an organic electroluminescence display comprising:
forming an organic electroluminescence device which emits light,
forming a sealing layer sealing the organic electroluminescence device,
forming concave parts by selectively removing a surface of the sealing layer in a non-opening area, and
forming a coloring layer in the concave parts of the sealing layer.

17. A method for producing an organic electroluminescence display comprising:
forming an organic electroluminescence device which emits light,
forming a sealing layer sealing the organic electroluminescence device,
forming concave parts by using a plain pattern which surrounds a non-opening area of the sealing layer in lattice (igeta) form, and
forming a coloring layer in the concave parts of the sealing layer.

18. A method for producing an organic electroluminescence display comprising:
forming an organic electroluminescence device which emits light,
forming a sealing layer sealing the organic electroluminescence device,
forming an ink-receiving layer on the sealing layer, and
forming a coloring layer by penetrating ink at certain positions of the ink-receiving layer.

19. The method for producing an organic electroluminescence display according to claim 11, wherein the coloring layer is formed by an ink jet method.

20. A method for producing an organic electroluminescence display comprising:
forming an organic electroluminescence device which emits light,
forming a sealing layer containing an ultraviolet-ray shading material, which seals the organic electroluminescence device, and
forming a coloring layer on the sealing layer by ultraviolet-ray photolithography.

21. A method for producing an organic electroluminescence display comprising:
forming an organic electroluminescence device which emits light,
forming a sealing layer sealing the organic electroluminescence device,
forming an ultraviolet-ray reflecting multi-layer film on the sealing layer, and
forming a coloring layer on the multi-layer film by ultraviolet-ray photolithography.

22. A method for producing an organic electroluminescence display comprising:
forming an organic electroluminescence device which emits light,
forming a sealing layer sealing the organic electroluminescence device,
applying a polymer containing an ultraviolet-ray absorber on a top surface of the sealing layer, and
forming a coloring layer on the polymer containing an ultraviolet-ray absorber by ultraviolet-ray photolithography.

23. The method for producing an organic electroluminescence display according to claim 11, wherein the organic electroluminescence device, the sealing layer and the coloring layer are formed on a supporting substrate, and then
a sealing substrate is adhered with the supporting substrate.
